Europäisches Patentamt

European Patent Office

Office européen des brevets

(19)

(11) Numéro de publication: **0 279 345 B1**

## (12) FASCICULE DE BREVET EUROPEEN

(45) Date de publication de fascicule du brevet:
24.04.91

(21) Numéro de dépôt: 88101940.0

(22) Date de dépôt: 10.02.88

(51) Int. Cl.⁵: **H02M 3/07, H03F 1/30, G05F 3/24**

(54) **Dispositif comportant un circuit électronique de traitement d'un signal analogique.**

(30) Priorité: **19.02.87 FR 8702356**

(43) Date de publication de la demande:
**24.08.88 Bulletin 88/34**

(45) Mention de la délivrance du brevet:
**24.04.91 Bulletin 91/17**

(84) Etats contractants désignés:
**CH DE GB LI NL SE**

(56) Documents cités:
**DE-A- 2 708 022**
**FR-A- 2 232 139**
**US-A- 4 186 436**

**PATENT ABSTRACTS OF JAPAN, vol. 6, no.
166 (P-138), 31 août 1982, page 9 P 138; &
JP-A-57 81 622 (NIPPON DENKI K.K.)
21-05-1982**

(73) Titulaire: **EM Microelectronic-Marin SA**

**CH-2074 Marin(CH)**

(72) Inventeur: **Sahm, Hans
Saazerstrasse 12
W-8560 Lauf(DE)**

(74) Mandataire: **de Montmollin, Henri et al
ICB Ingénieurs Conseils en Brevets SA Passage Max Meuron 6
CH-2001 Neuchâtel(CH)**

## Description

La présente invention a pour objet un dispositif comportant un circuit électronique de traitement d'un signal électrique analogique et un circuit élévateur de tensions destiné à être relié à une source d'alimentation en énergie électrique pour produire une tension d'alimentation dudit circuit électronique. (FR-A- 2232139)

De nombreux appareils comprenant un dispositif du genre de celui qui est mentionné ci-dessus, tels que des prothèses auditives, des télécommandes de jouets, des récepteurs radio miniatures, etc...., ont des dimensions si faibles que la source d'alimentation en énergie électrique de ce dispositif ne peut être constituée que par une pile ou un accumulateur rechargeable miniature. Une telle pile ou un tel accumulateur ne comporte forcément qu'un seul élément électro-chimique. (DE-A-2708022)

Une pile ou un acoumulateur ne comportant qu'un seul élément fournit à l'état neuf une tension de 1,5 à 1,7 V ou, respectivement, une tension de 2 à 2,2 V. Ces tensions diminuent évidemment lorsque cette pile ou cet accumulateur se décharge.

Le circuit électronique que comporte un dispositif du genre de celui qui est mentionné ci-dessus comprend généralement un ou plusieurs amplificateurs qui nécessitent pour leur fonctionnement correct une tension d'alimentation minimum de 2 Volts environ.

C'est la raison pour laquelle un tel dispositif comprend généralement un circuit élévateur de tension qui est destiné à produire cette tension d'alimentation des amplificateurs à partir de la tension fournie par la pile ou l'accumulateur mentionné ci-dessus.

Les faibles dimensions des appareils utilisant ces dispositifs ainsi que la nécessité de les produire à un prix auusi bas que possible imposent en outre que tous les composants du dispositif électronique soient réalisés dans un seul et même circuit intégré.

Or, un circuit élévateur de tension réalisé dans un circuit intégré, sans composant extérieur à ce circuit intégré, a des caractéristiques électriques assez mauvaises.

Notamment, sa résistance interne est élevée, de sorte que sa tension de sortie dépend fortement du courant consommé par les circuits qu'il alimente.

En outre, la tension produite par un tel circuit élévateur est très variable en fonction de la tension de la pile ou de l'accumulateur qui l'alimente.

Il n'est pratiquement pas possible de corriger ces défauts, même partiellement, en intercalant un stabilisateur de tension entre cet élévateur de tension et les circuits qu'il alimente, car un tel stabilisateur nécessite, pour fonctionner correctement, une tension d'entrée nettement plus élevée que la tension qu'il doit fournir.

Or, un circuit élévateur de tension tel que celui mentionné ci-dessus ne peut pratiquement pas fournir cette tension élevée d'entrée du stabilisateur de tension, à cause des chutes de tension qui se produisent obligatoirement dans ses divers étages et qui ne sont pas beaucoup inférieures à la tension fournie par la pile ou par l'accumulateur.

Le but de la présente invention est de proposer un dispositif comportant un circuit électronique de traitement d'un signal électrique analogique et un circuit élévateur de tension destiné à être relié à une source d'alimentation en énergie électrique pour produire une tension d'alimentation dudit circuit électronique et comportant une première et une deuxième borne entre lesquelles ladite tension d'alimentation est produite qui ne présente pas les inconvénients mentionnés ci-dessus, c'est-à-dire dans lequel la tension d'alimentation du circuit électronique que comporte ce dispositif ne varie pas au delà des limites entre lesquelles ce circuit fonctionne correctement, malgré les caractéristiques défavorables du curcuit élévateur de tension produisant cette tension d'alimentation.

Ce but est atteint grâce au fait que le dispositif selon l'invention comporte des moyens pour faire varier la résistance interne du circuit électronique que comporte le dispositif en raison inverse de la tension alimentant ce circuit électronique.

L'invention va être décrite maintenant à l'aide du dessin dans lequel:

- la figure 1 est un schéma-bloc d'un exemple de dispositif selon l'invention;
- la figure 2 représente les caractéristiques du circuit élévateur de tension de la figure 1; et
- la figure 3 est un schéma d'un exemple du circuit de commande et d'une partie du circuit électronique de la figure 1.

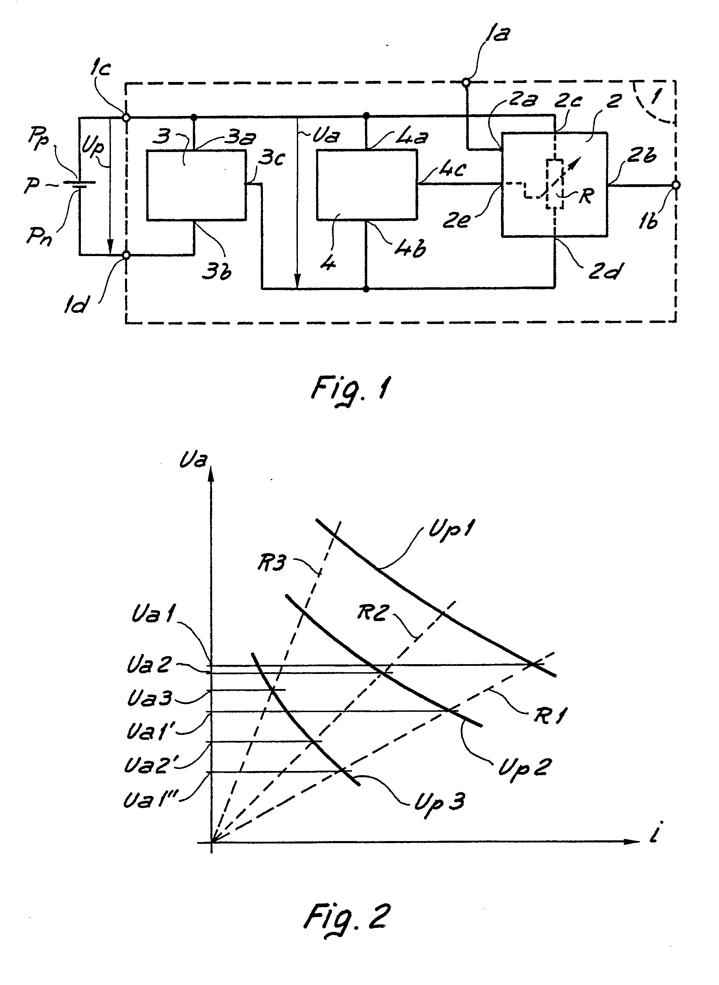

Le dispositif 1 représenté schématiquement à la figure 1 est destiné à équiper une prothèse auditive.

Vu les faibles dimensions d'une telle prothèse, tous les éléments du dispositif qui vont être énumérés ci-dessous sont réalisés dans un circuit intégré, par une des techniques de fabrication bien connues dans ce domaine et qui ne seront pas décrites ici.

Le dispositif 1 comporte notamment un circuit amplificateur 2 dont l'entrée 2a est reliée, par l'intermédiaire d'une borne 1a du dispositif 1, à un microphone non représenté. La sortie 2b de l'amplificateur 2 est reliée, par l'intermédiaire d'une borne 1b du dispositif 1, à un haut-parleur également non représenté.

L'amplificateur 2 est bien connu et ne sera pas décrit en détail ici, sinon pour rappeler qu'il comporte généralement des filtres dont les caractéristiques sont déterminées de manière que la variation de son gain en fonction de la fréquence du signal qu'il reçoit sur son entrée 2a soit adaptée aux déficiences auditives de la personne portant la prothèse.

Ces filtres, qui sont généralement du type dit "à condensateurs commutés", sont également bien connus et ne seront pas décrits en détail ici. On peut simplement relever que ces filtres comportent chacun au moins un amplificateur opérationnel dont un exemple sera décrit plus loin.

Le dispositif 1 comporte deux bornes d'alimentation 1c et 1d qui sont reliées respectivement à la borne positive Pp et à la borne négative Pn d'une pile P délivrant une tension Up.

Le dispositif 1 comporte encore un circuit élévateur de tension 3 dont les bornes d'alimentation 3a et 3b sont reliées respectivement aux bornes 1c et 1d du dispositif 1, et donc aux bornes Pp et Pn de la pile P. La constitution et le fonctionnement de ce circuit élévateur de tension 3 seront évoqués plus loin. Il faut simplement noter ici que, dans cet exemple, le potentiel de sa sortie 3c est plus négatif que celui de sa borne d'alimentation 3b, pour autant que le courant qu'il doit fournir ne soit pas trop élevé.

Les bornes d'alimentation 2c et 2d du circuit électronique 2 sont respectivement reliées à la borne 1c du dispositif 1, et donc à la borne Pp de la pile P, et à la borne 3c du circuit élévateur de la tension 3. La tension d'alimentation Ua du circuit électronique 2, qui est égale à la différence entre les potentiels des bornes 3a et 3c du circuit élévateur de tension 3, est donc plus élevée que la tension Up de la pile P, à condition cependant que le courant consommé par le circuit 2 ne soit pas trop élevé.

Le dispositif 1 comporte en outre un circuit de commande 4 dont les bornes d'alimentation 4a et 4b sont reliées respectivement à la borne 1c du dispositif 1 et a la borne 3c du circuit élévateur de tension 3. Le circuit de commande 4 est donc alimenté par la même tension que le circuit électronique 2.

Le circuit de commande 4 comporte une sortie 4c qui est reliée à une entrée 2e du circuit 2. Ce circuit 4 produit, à cette sortie 4c, un signal qui commande des moyens faisant partie du circuit 2 de manière que la résistance interne de ce dernier varie en raison inverse de la tension Ua, c'est-a-dire de manière que cette résistance interne augmente lorsque la tension Ua diminue, et vice-versa.

La résistance interne du circuit 2 est symbolisée par la résistance variable R branchée entre les bornes 2c et 2d et dessinée en pointillé dans la figure 1.

Un exemple de ces circuits 2 et 4 sera décrit en détail plus loin, de même que leur fonctionnement.

Comme cela a été mentionné ci-dessus, la place à disposition dans la prothèse auditive équipée du dispositif 1 est très limitée. Cela implique que le circuit élévateur de tension 3 ne peut comporter aucun composant extérieur au circuit intégré dans lequel le dispositif 1 est réalisé, et notamment aucun transformateur ou bobine d'auto-induction.

Le circuit élévateur de tension 3 doit donc être par exemple du genre de ceux qui comportent une pluralité de condensateurs alternativement chargés par la source d'alimentation du circuit et déchargés dans un condensateur de sortie du circuit.

Un tel circuit élévateur de tension ne sera pas décrit en détail ici car il est bien connu des spécialistes. Il faut simplement noter que les condensateurs qu'il comporte ont forcément des capacités assez faibles, puisqu'ils doivent être réalisés dans le circuit intégré. Il en découle notamment que la résistance interne de ce circuit élévateur de tension 3 est très élevée, comme cela est visible dans la figure 2 qui représent schématiquement la variation de la tension Ua fournie par le circuit élévateur de tension 3 en fonction du courant i consommé par les circuits 2 et 4 du dispositif 1, pour trois tensions différentes de la pile P, Up1, Up2 et Up3. La tension Up1 est, par exemple, celle que fournit la pile P lorsqu'elle est neuve, la tension Up2 est celle que fournit typiquement la pile P pendant la plus grande partie de sa vie utile, et la tension Up3 est celle que fournit la pile P lorsqu'elle est presque complètement épuisée.

Il faut noter que, en pratique, la consommation du circuit de commande 4 est beaucoup plus faible que celle du circuit électronique 2, comme cela sera rendu évident par la description de ces deux circuits qui sera faite plus loin. On admettra donc, pour simplifier, que le courant i est celui qui est consommé par le circuit électronique 2.

La résistance interne élevée du circuit élévateur de tension 3 mentionnée ci-dessus se traduit par la forte pente négative que présentent les courbes caractéristiques de la figure 2. Cette pente peut attindre plusieurs dixièmes de volt par micro-ampère, ce qui correspond à une résistance interne de plusieurs centaines de kilo-ohms.

En outre, la faible capacité des condensateurs que comporte le circuit élévateur de tension 3 a également comme conséquence que la variation de la tension Ua en fonction de la tension Up pour une valeur donnée de la résistance interne R du circuit 2 est très importante, comme cela est visible sur la figure 2. Ainsi, par exemple, dans un dispositif expérimental réalisé par la déposante où le circuit 2 a une résistance interne R de 200 kilo-ohms environ, la tension Ua varie de 2,8 volts environ à 1,2 volts environ lorsque la tension Up varie de 1,4 volts à 1 volt si le circuit 4 et les moyens correspondants du circuit 2 ne sont pas en fonction.

Comme cela a été déjà mentionné, le circuit de commande 4 et le circuit électronique 2 sont agencés de manière que la résistance interne R de ce dernier varie en raison inverse de la tension Ua.

Admettons pour commencer que la tension Up de la pile P a la valeur Up1, et que le circuit 4 commande le circuit 2 de manière que la résistance interne R de ce dernier ait la valeur R1 représentée dans la figure 2 par la droite portant cette référence.

Dans ces conditions, la tension Ua prend la valeur Ua1 indiquée dans la figure 2.

Lorsque la tension de pile Up diminue et prend, par exemple, la valeur Up2, la tension Ua a tendance à diminuer.

En l'absence du circuit 4 et des moyens correspondants du circuit 2, cette tension Ua prendrait la valeur Ua1'. Mais le circuit 4 réagit à cette diminution de la tension Ua en commandant une augmentation de la résistance interne R du circuit 2, de manière que cette résistance interne R prenne la valeur R2 représentée à la figure 2 par la droite portant cette référence. Il en résulte que la tension Ua ne diminue que jusqu'à la valeur Ua2 qui est beaucoup plus proche de la valeur Ua1 que la valeur Ua1' mentionnée ci-dessus.

De même, si la tension Up diminue jusqu'à la valeur Up3, le circuit 4 réagit à la diminution de la tension Ua qui en résulte en augmentant encore la résistance interne R du circuit 2, qui prend alors la valeur R3 représentée à la figure 2 par la droite portant cette reference.

Il en résulte que la tension Ua ne diminue que jusqu'à la valeur Ua3, alors qu'elle aurait diminué jusqu'à la valeur Ua2' si la résistance interne R du circuit 2 était restée à la valeur R2, et même jusqu'à la valeur Ua1" si cette résistance interne R étant restée à la valeur R1.

En résumé, on voit que le circuit de commande 4 et les moyens qui lui sont associés dans le circuit 2 provoquent une nette diminution des variations de la tension Ua en fonction des variations de la tension Up, en modifiant la résistance interne R de ce circuit 2 en raison inverse de cette tension Ua.

Un processus semblable à celui qui a été décrit ci-dessus se déroule évidemment si la résistance interne R du circuit 2 se modifie pour une raison quelconque sans que cette modification soit commandée par le curcuit 4. Dans un tel cas, le circuit 4 réagit à la variation de la tension Ua due à cette modification de la résistance interne R du circuit 2 en redonnant à cette résistance interne R sa valeur initiale, ce qui redonne également sa valeur initiale à la tension Ua.

Il est évident que le processus décrit ci-dessus est continu, c'est-à-dire que si la tension Up varie de manière continue entre ses valeurs Up1 et Up3, la tension Ua varie également de manière continue entre ses valeurs Ua1 et Ua3.

Le processus décrit ci-dessus l'a été dans le cas où la tension Up diminue de sa valeur Up1 à sa valeur Up3. Il est évident que ce processus est réversible, c'est-a-dire que si la tension Up augmente au lieu de diminuer, pour une raison quelconque, le circuit 4 et les moyens qui lui sont associés dans le circuit 2 réagissent à l'augmentation de la tension Ua qui en résulte en diminaut la résistance interne R de ce circuit 2, ce qui limite cette augmentation de la tension Ua.

Comme cela a déjà été mentionné, le dispositif selon l'invention est destiné, dans l'exemple décrit, à équiper une prothèse auditive. Il comporte donc, de manière bien connue, des filtres passe-bas, passe-haut et passe-bande. Ces filtres peuvent être de différents types et ne seront pas décrits en détail ici car ils sont également bien connus et n'ont pas de rapport direct avec l'invention. Il faut simplement relever qu'ils comportent tous au moins un amplificateur opérationnel.

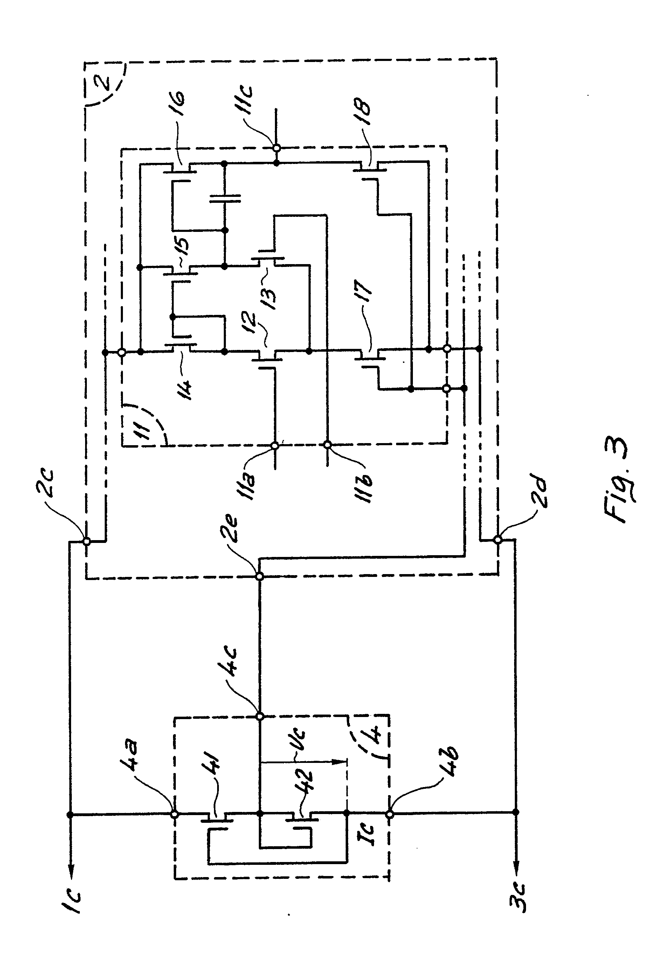

Un exemple de l'un de ces amplificateurs opérationnels est représenté à la figure 3 avec la référence 11.

Cet amplificateur 11 comporte de manière classique deux entrées 11a et 11b et une sortie 11c. Les liaisons de ces entrées 11a et 11b et de cette sortie 11c avec les autres composants du curcuit 2, de même que ces autres composants, n'ont pas été représentés car ils sont classiques et n'ont pas de rapport direct avec l'invention.

Egalement de manière classique, l'amplificateur 11 comporte deux transistors 12 et 13 qui sont, dans cet exemple, des transistors MOS de type N. Les électrodes de commande de ces transistors 12 et 13 sont respectivement reliées aux entrés 11a et 11b.

Les drains des transistors 12 et 13 sont reliés de la manière représentée à la figure 3 à trois transistors MOS de type P 14, 15 et 16. Les interconnexions de ces transistors 12 à 16 ne seront pas décrites ici, car elles sont classiques et n'ont pas de rapport direct avec l'invention. Il faut simplement relever que les sources des transistors 14, 15 et 16 sont reliées à la borne 2c du circuit 2 et donc à la borne 1c du dispositif 1 (figure 1).

Toujours de manière classique, les source des transistors 12 et 13 sont reliées ensemble au drain d'un transistor MOS de type N 17, et la source du transistor 16 est reliée au drain d'un transistor MOS 18, également de type N. Les sources de ces transistors 17 et 18 sont reliées à la borne 2d du circuit 2 et donc à la borne 3c du circuit élévateur de tension 3 (figure 1).

Dans les amplificateurs opérationnels connus, le transistor 17 est destiné à fournir aux transistors 12 et 13 un courant constant ayant une intensité déterminée de manière que le point de travail de ces transistors 12 et 13 soit celui qui a été choisi.

De même, toujours dans les amplificateurs connus, le transistor 18 est destiné à limiter le courant qui peut être consommé par le circuit, non représenté, qui est relié à la sortie 11c. Les électrodes de commande de ces transistors 17 et 18 sont donc reliées à des sources fournissant une tension fixe déterminée de manière que les courants mentionnés ci-dessus alient les intensités voulues.

Dans la présente invention, par contre, les transistors 17 et 18, ainsi que les transistors correspondants des autres amplificateurs faisant partie du circuit 2 et non représentés dans cette figure 3, constituent les moyens, mentionnés dans la description de la figure 1, qui sont associés au circuit de commande 4 pour faire varier la résistance interne R du circuit 2 en raison inverse de la tension d'alimentation Ua.

A cet effet, leurs électrodes de commande sont reliées à la borne 2e du circuit 2 et donc à la sortie 4c du circuit de commande 4.

Ce dernier, qui est également représenté dans la figure 3, comporte un transistor MOS de type P 41 et un transistor MOS de type N 42.

Les sources de ces transistors 41 et 42 sont respectivement reliées aux bornes 4a et 4b du circuit 4 et donc à la borne 1c du dispositif 1 et à la borne 3c du circuit élévateur de tension 3 (figure 1).

Les drains de ces transistors 41 et 42 sont reliés l'un à l'autre ainsi qu'à la sortie 4c du circuit 4.

En outre, l'électrtode de commande du transistor 41 est reliée à la borne 4b du circuit 4, et l'électrode de commande du transistor 42 est reliée à son drain. Ce transistor 42 a donc pratiquement la caractéristique d'une simple résistance.

Le courant Ic qui traverse les transistors 41 et 42 déterminé essentiellement par la tension qui existe entre l'électrode de commande et la source du transistor 41, qui est la tension Ua fournie par le circuit élévateur 3.

Ce courant Ic produit dans le transistor 42 une chute de tension Uc qui constitue la tension de sortie du circuit de commande 4 et qui est appliquée entre l'électrode de commande et la source des transistors 17 et 18.

On voit qu'une diminution de la tension Ua provoque une diminution du courant Ic, qui entraîne à son tour une diminution de la tension Uc, et donc une diminution du courant circulant dans les transistors 17 et 18 ou, ce qui est équivalent, une augmentation de la résistance interne de ces transistors 17 et 18.

Il en est évidemment de même pour tous les transistors, semblables aux transistors 17 et 18, qui font partie des autres amplificateurs, non représentés, que comporte le circuit 2 et dont l'électrode de commande et la source sont également reliées respectivement à l'entrée 2e et à la borne 2d du circuit 2.

Le processus décrit ci-dessus étant évidemment réversible, une augmentation de la tension Ua provoque bien entendu une diminution de la résistance interne des transistors 17 et 18 ainsi que de tous les autres transistors mentionnés ci-dessus.

La résistance interne R du circuit 2 dépend bien entendu directement de la résistance interne des transistors tels que les transistors 17 et 18.

On voit donc que le circuit 4 et les transistors qui lui sont associés dans le circuit 2 font varier la résistance interne R de ce circuit 2 en raison inverse de toute variation de la tension Ua produite par le circuit élévateur de tension 3. Les conséquences de cette variation de la résistance interne R du circuit 2 ont été décrites ci-dessus en liaison avec les figures 1 et 2 et ne seront pas décrites à nouveau ici.

Les caractéristiques du circuit 4 et des transistors qui lui sont associés dans le circuit 2 doivent bien entendu être adaptées aux caractéristiques du circuit élévateur de tension 3, de manière que la résistance interne R du circuit 2 varie en fonction de la tension Ua de la manière et avec les effect décrits ci-dessus.

Connaissant les caractéristiques du circuit élévateur de tension 3 et les valeurs extrêmes de la tension Ua pour lesquelles le circuit 2 fonctionne encore correctement, par exemple les valeurs, Ua1 et Ua3 de la figure 2, on peut déterminer facilement les valeurs extrêmes que doit prendre la résistance interne R du circuit 2, c'est-à-dire les valeurs R1 et R3.

Connaissant en outre le nombre de transistors tels que les transistors 17 et 18 que comporte le circuit 2, on peut également facilement déterminer les valeurs que doit prendre le courant passant dans chacun d'eux pour que la résistance interne R du circuit 2 ait ces valeurs R1 et R3.

Il est bien connu que le courant passant dans un transistor MOS dépend directement de la tension appliquée entre son électrode de commande et sa source ainsi que du rapport entre la largeur et la longueur de son canal.

Une fois que les valeurs extrêmes du courant qui doit passer dans les transistors tels que les transistors 17 et 18 sont connues, il est donc possible de fixer les dimensions du canal de chacun de ces transistors et les valeurs que doit prendre la tension Uc appliquée le circuit de commande 4 entre leur électrode de commande et leur source pour chacune de ces valeurs extrêmes de courant.

On peut ensuite, par exemple, choisir arbitrairement les dimensions du canal du transistor 42, ce qui détermine la valeur de sa résistance. Connaissant cette résistance, on peut calculer la valeur que doit prendre le courant Ic pour chacune des valeurs extrêmes de la tension Uc déterminées ci-dessus.

Les dimensions du canal du transistor 41 peuvent ensuite être calculées de manière que la courant Ic prenne ces valeurs extrêmes lorsque la tension Ua a ses valeurs extrêmes admissible mentionées ci-dessus.

Dans l'exemple qui vient d'être décrit, le signal de commande produit par le circuit 4 pour faire varier la résistance interne R du circuit 2 en raison inverse de la tension Ua est constitué par la tension Uc.

Dans une autre forme d'exécution du dispositif selon l'invention, ce signal de commande pourrait être constitué par un courant. Dans une telle forme d'exécution, le circuit de commande 4 pourrait comporter une source de courant délivrant un courant variable en fonction de la tension Ua, et le circuit 2 pourrait comporter des moyens répondant à ce courant pour faire varier la résistance interne du circuit 2 d'une manière analogue à celle qui a été décrite ci-dessus.

Ces derniers moyens pourraient par exemple comprendre un ou plusieurs transistors dont le drain et l'électrode de commande seraient reliés l'un à l'autre, comme ceux du transistor 42 de la figure 3, et qui répondraient au courant produit par la source mentionnée ci-dessus pour produire une tension de commande comparable à la tension Uc produite par ce transistor 42. Les moyens pour faire varier la résistance interne du circuit 2 comprendraient en outre, toujours par exemple, des transistors jouant le même rôle qui les transistors 17 et 18 de la figure 3 en rêponse à la tension de commande mentionée ci-dessus.

L'invention a été décrite dans un cas où le circuit de commande 4 et le circuit électronique 2 sont réalisés en utilisant des transistors MOS, mais il est clair que ces circuits pourraient également être réalisés en utilisant des transistors bipolaires.

De même, il est clair que l'invention n'est pas limitée au cas décrit où le dispositif est destiné à équiper une prothèse auditive, et qu'elle peut être utilisée avec profit dans toute sorte d'appareils portables équipés de dispositifs électroniques, notamment dans les appareils de faibles dimensions dans lesquels le dispositif électronique est réalisé sous la forme d'un circuit intégré et est alimenté par une pile ou une batterie rechargeable.

## Revendications

1. Dispositif comportant un circuit électronique (2) de traitement d'un signal électrique analogique et un circuit élévateur de tension (3) destiné à être relié à une source (P) d'alimentation en énergie électrique pour produire une tension d'alimentation (Ua) dudit circuit électronique (2) et comportant une première (3a) et une deuxième (3c) borne entre lesquelles ladite tension d'alimentation (Ua) est produite, caractérisé par le fait qu'il comporte en outre des moyens (4, 17, 18) pour faire varier la résistance interne (R) dudit circuit électronique (2) en raison inverse de ladite tension d'alimentation (Ua).

2. Dispositif selon la revendication 1, caractérisé par le fait que lesdits moyens (4, 17, 18) pour faire varier ladite résistance interne (R) comportent des moyens (4) pour produire un signal de commande (Uc) dépendant de ladite tension d'alimentation (Ua) et des moyens (17, 18) incorporés audit circuit électronique (2) et répondant audit signal de commande (Uc) pour faire varier ladite résistance interne (R).

3. Dispositif selon la revendication 2, caractérisé par le fait que lesdits moyens (4) pour produire un signal de commande (Uc) comportent un premier transistor MOS (41) dont la source et l'électrode de commande sont respectivement reliées à ladite première (3a) et à ladite deuxième borne (3c) dudit circuit élévateur de tension (3), et un deuxième transistor MOS (42) dont la source est reliée à ladite deuxième borne (3c) dudit circuit élévateur de tension (3) et dont l'électrode de commande et le drain sont reliés, ensemble, au drain dudit premier transistor (41), ladite tension de commande (Uc) étant constituée par la chute de tension produite entre le drain et la source dudit deuxième transistor (42) par le courant passant dans ledit premier transistor (41) en réponse à ladite tension d'alimentation (Ua) appliquée entre l'électrode de commande et la source dudit premier transistor (41), et en ce que lesdits moyens (17, 18) incorporés audit circuit électronique (2) comportent au moins un troisième transistor MOS (17, 18) dont la source est reliée à ladite deuxième borne (3c) dudit circuit élévateur de tension (3) et dont l'électrode de commande est reliée aux drains desdits premier (41) et deuxième (42) transistors MOS.

## Claims

1. Device comprising an electronic circuit (2) for processing an analog electric signal and a voltage multiplying circuit (3) intended to be connected to an electrical energy supplying source (P) for producing a supply voltage (Ua) for said electronic circuit (2) and comprising a first (3a) and a second (3c) terminal across which said supply voltage (Ua) is produced, characterized by the fact that it further comprises means (4, 17, 18) for varying the internal resistance (R) of said electronic circuit (2) in inverse ratio to said supply voltage (Ua).

2. Device according to claim 1, characterized by the fact that said means (4, 17, 18) for varying said internal resistance (R) include means (4) for producing a control signal (Uc) depending on said supply voltage (Ua) and means (17, 18) incorporated in said electronic circuit (2) and responding to said control signal (Uc) for varying said internal resistance (R).

3. Device according to claim 2, characterized by the fact that said means (4) for producing a control signal (Uc) include a first MOS transistor (41) whose source and gate are respectively connected to said first (3a) and second (3c) terminals of said voltage multiplying circuit (3), and a second MOS transistor (42) whose source is connected to said second terminal (3c) of said voltage multiplying circuit (3) and whose gate and drain are together connected to the drain of said first transistor (41), said control voltage (Uc) being constituted by the voltage drop produced across the drain and the source of said second transistor (42) by the current flowing in said first transistor (41) in response to said supply voltage (Ua) applied between the gate and the source of said first transistor (41), and in that said means (17, 18) incorporated in said electronic circuit (2) include at least a third MOS transistor (17, 18) whose source is connected to said second terminal (3c) of said voltage multiplying circuit (3) and whose gate is connected to the drains of said first (41) and second (42) MOS transistors.

**Ansprüche**

1. Anordnung, umfassend einen elektronischen Schaltkreis (2) für die Verarbeitung eines analogen elektrischen Signals und einen Spannungsanhebeschaltkreis (3), bestimmt zum Anschluß an eine Speisequelle (P) elektrischer Energie zum Erzeugen einer Speisespanung (Ua) des elektronischen Schaltkreises (2) und umfassend eine erste (3a) und eine zweite (3c) Klemme, zwischen welchen die Speisespannung (Ua) erzeugt wird, dadurch gekennzeichnet, daß sie ferner Mittel (4, 17, 18) umfaßt zum Verändern des Innenwiderstandes (R) des elektronischen Schaltkreises (2) in umgekehrter Abhängigkeit von der Speisespannung (Ua).

2. Anordnung nach Anspruch 1, dadurch gekennzeichnet, daß die Mittel (4, 17, 18) zum Verändern des Innenwiderstandes (R) Mittel (4) umfassen zum Erzeugen eines Steuersignals (Uc), abhängend von der Speisespannung (Ua), sowie Mittel (17,18) eingefügt in den elektronischen Schaltkreis (2) und ansprechend auf das Steuersignal (Uc) zum Verändern des Innenwiderstandes (R).

3. Anordnung nach Anspruch 2, dadurch gekennzeichnet, daß die Mittel (4) zum Erzeugen eines Steuersignals (Uc) einen ersten MOS Transistor (41) umfassen, dessen Source und Gate an die erste (3a) bzw. zweite (3c) Klemme des Spannungsanhebekreises (3) angeschlossen sind sowie einen zweiten MOS Transistor (42), dessen Source mit der zweiten Klemme (3c) des Spannungsanhebeschaltkreises (3) und dessen Gate und Drain gemeinsam an dem Drain des ersten Transistors (41) angeschlossen sind, wobei die Steuerspannung (Uc) gebildet wird vom Spannungsabfall, erzeugt zwischen dem Drain und der Source des zweiten Transistors (42) durch den den ersten Transistor (41) durchfließenden Strom im Ansprechen auf die Speisespannung (Ua), angelegt zwischen der Steuerelektrode und der Source des ersten Transistors (41), und daß die Mittel (17, 18) eingefügt in den elektronischen Schaltkreis (2) mindestens einen dritten MOS Transistor (17, 18) umfassen, dessen Source verbunden ist mit der zweiten Klemme (3c) des Spannungsanhebekreises (3) und dessen Gate verbunden ist mit den Drains des ersten (41) und des zweiten (42) MOS Transistors.

Fig. 1

Fig. 2

Fig. 3